Europäisches Patentamt

European Patent Office

Office européen des brevets

(19)

(11) Veröffentlichungsnummer: **0 035 730**

A2

# (12) EUROPÄISCHE PATENTANMELDUNG

(21) Anmeldenummer: 81101489.3

(22) Anmeldetag: 02.03.81

(51) Int. Cl.³: **B 41 N 1/08**

(30) Priorität: 10.03.80 DE 3009103

(43) Veröffentlichungstag der Anmeldung:
16.09.81 Patentblatt 81/37

(84) Benannte Vertragsstaaten:
BE CH DE FR GB IT LI NL SE

(71) Anmelder: HOECHST AKTIENGESELLSCHAFT
Postfach 80 03 20
D-6230 Frankfurt/Main 80(DE)

(72) Erfinder: Frass, Werner, Dr.
Erbsenacker 37
D-6200 Wiesbaden(DE)

(72) Erfinder: Usbeck, Gerhard, Dr.
Im Nachtschatten 10
D-6200 Wiesbaden(DE)

(54) Verfahren zur Modifizierung der Oberfläche von Druckplatten-Trägermaterialien aus Aluminium und Verfahren zur Herstellung von Druckplatten aus diesen Materialien.

(57) Die Erfindung betrifft ein Verfahren zur Modifizierung mindestens einer Oberfläche von Druckplatten-Trägermaterialien auf der Basis von Aluminum oder seinen Legierungen mit wäßrig-alkalischen Lösungen. Die Modifizierung erfolgt nach der elektrochemischen Aufrauhung des Materials in verdünnten wäßrigen Säuren oder in wäßrigen Salzlösungen. Als Modifizierung wird ein Flächenabtrag von der aufgerauhten Oberfläche des Materials in einem Umfang von 0,4 bis 3,0 g/m², insbesondere von 0,5 bis 2,5 g/m², mit einer wäßrig-alkalischen Lösung eines pH-Werts von $\geq$ 11, insbesondere $\geq$ 12, während einer Dauer von 1 bis 90 sec und bei einer Temperatur von 30° C bis zum Siedepunkt der Lösung durchgeführt.

Die Erfindung betrifft auch ein Verfahren zur Herstellung einer Druckplatte unter Verwendung des modifizierten Trägermaterials, bei dem auf die aufgerauhte, modifizierte und gegebenenfalls anodisch oxidierte Oberfläche des Trägermaterials eine lichtempfindliche Schicht aufgebracht wird.

HOECHST AKTIENGESELLSCHAFT
KALLE Niederlassung der Hoechst AG

Hoe 80/K 006         -1-        27. Februar 1981
WLK-Dr.I.-dg

Verfahren zur Modifizierung der Oberfläche von Druckplatten-Trägermaterialien aus Aluminium und Verfahren zur
Herstellung von Druckplatten aus diesen Materialien

Die Erfindung betrifft ein Verfahren zur Modifizierung
der Oberfläche von Druckplatten-Trägermaterialien auf der
Basis von Aluminium oder seinen Legierungen nach der
elektrochemischen Aufrauhung und ein Verfahren zur
Herstellung von Druckplatten aus diesem Material.

Beim Flachdruckprozeß wird die Differenzierung zwischen
Bildstellen und Nichtbildstellen nicht wie beim
Hochdruck- oder Tiefdruckprozeß durch die Geometrie der
druckenden bzw. nicht-druckenden Stellen, d. h. durch
erhabene oder tiefer gelegte Stellen der Druckform
bewirkt, sondern druckende und nicht-druckende Stellen
unterscheiden sich beim Flachdruckprozeß vielmehr durch
ihre chemische Natur. Die Bildstellen haben oleophilen
Charakter, während die Nichtbildstellen hydrophil bzw.
weniger oleophil sind. Durch Befeuchten der Druckform
wird beim Drucken auf den hydrophilen Stellen der Druckform ein dünner Wasserfilm (Feucht- oder Wischwasser)
erzeugt. Wenn dann in der nachfolgenden Stufe des
Einfärbens die Druckfarbe auf die Druckform aufgetragen
wird, verhindert der Wasserfilm an den Nichtbildstellen
die Übertragung der Druckfarbe, so daß sie nur auf die
oleophilen Bildstellen der Druckform übertragen wird;
auch ein Einfärben der Druckform vor dem Einsatz des
Feuchtwassers ist bekannt.

HOECHST AKTIENGESELLSCHAFT
KALLE Niederlassung der Hoechst AG

-2-

Während des Druckvorgangs muß auf der Oberfläche der Druckform ein bestimmtes Gleichgewicht zwischen Feuchtwasser und Druckfarbe bestehen; ist der Wasserfilm auf den Nichtbildbereichen zu dünn, so wird sich dort Druckfarbe ansetzen, die Druckform "tont"; befindet sich dagegen zu viel Wasser auf der Oberfläche der Druckform, so werden sogar die oleophilen Bildstellen vom Feuchtwasser "überschwemmt", die Platte "läuft blind". Diese beiden negativen Auswirkungen begrenzen nach beiden Seiten den Bereich der Feuchtwasserzugabe, der zur Erzielung praxisgerechter Drucke erforderlich ist. Der Drucker wird jedoch insbesondere aus folgenden Gründen bestrebt sein, seinen Auftrag mit einer möglichst geringen Menge an Feuchtwasser zu drucken:

- die Zusätze des Feuchtwassers sind ein Kostenfaktor,

- die teure Druckfarbe wird bei geringerer Feuchtwasserzugabe besser ausgenutzt,

- das Druckpapier kann sich verziehen, wenn es zu viel Feuchtwasser aufnimmt, was dann besonders bei Mehrfarbenarbeiten zu "Passerschwierigkeiten" führen kann, d. h. der zweite und dritte Farbton können nicht mehr deckungsgleich auf den ersten Farbton gedruckt werden,

- die Gefahr von Papierbahnabrissen beim Rollenoffset ist um so größer, je mehr Feuchtwasser das Papier aufgenommen hat.

HOECHST AKTIENGESELLSCHAFT
KALLE Niederlassung der Hoechst AG

-3-

Eine Verbesserung der drucktechnischen Eigenschaften einer lithographischen Oberfläche muß aus den genannten Gründen die Hydrophilie und das "Ton"-Verhalten der Nichtbildstellen und den Wischwasserverbrauch der Druckform berücksichtigen. In der Praxis werden diese Eigenschaften oft zusammengefaßt als "Wasserführung" der Druckform bezeichnet.

Eine andere, sehr wichtige Eigenschaft einer Druckform betrifft ihre Leistungsfähigkeit, d. h. die Anzahl der verwertbaren Exemplare, die von ihr gedruckt werden können. Hierbei spielen Eigenschaften, wie z. B. die Abriebfestigkeit der oleophilen Bildstellen, ihre Sprödigkeit, ihre Haftung am Trägermaterial und damit also wiederum die Oberflächeneigenschaften des Trägermaterials eine entscheidende Rolle. Die Haftungseigenschaften einer Oberfläche können beispielsweise durch Aufrauhung der Oberfläche merklich verbessert werden; bei Aluminiumoberflächen kann man die Haftung darüber hinaus noch steigern, indem man anodisch eine Oxidschicht auf der aufgerauhten Oberfläche aufbaut.

Insbesondere elektrochemisch aufgerauhte Aluminiumoberflächen mit ihrer sehr feinkörnigen Struktur bewirken als Grenzschicht zwischen dem Trägermaterial und der lichtempfindlichen Schicht von Druckplatten bei den daraus herstellbaren Druckformen höchste Auflagen, dies kann noch durch eine zusätzliche anodische Oxidation der aufgerauhten Aluminiumoberfläche gesteigert werden.

HOECHST AKTIENGESELLSCHAFT
KALLE Niederlassung der Hoechst AG

-4-

Diese gesteigerte Auflage ist auch beim Vergleich einer einen elektrochemisch aufgerauhten und anodisierten Aluminiumträger aufweisenden Druckform mit solchen Druckformen zu beobachten, die ein Trägermaterial haben, das unter Verwendung von Schleifmitteln mechanisch aufgerauht und dann anodisiert worden ist.

Unter Zuhilfenahme schleifender Körnmittel mechanisch aufgerauhte Aluminiumoberflächen nehmen häufig bei der Anodisierung ein dunkelgraues bis schwarzes Aussehen an. Um diese Verfärbung der Aluminiumoberfläche zu verhindern, kann die mit schleifenden Körnmitteln mechanisch aufgerauhte Oberfläche nach der Aufrauhstufe und vor dem Anodisieren einem alkalischen abtragenden Beizschritt unterworfen werden. Man erhält dann helle Oxidoberflächen, wie sie bei der Anodisierung von elektrochemisch aufgerauhtem Aluminium unter bestimmten Bedingungen bereits ohne diesen intermediären Beizschritt erhalten werden. Dabei ist nicht auszuschließen, daß durch die abtragende Beizung des mechanisch aufgerauhten Aluminiumträgers die Hafteigenschaften der Oberfläche für eine organische Schicht verschlechtert werden, was sich bei einer Druckform als verminderte Auflagenleistung auswirken muß. Die Eigenschaften einer mechanisch, chemisch oder elektrochemisch aufgerauhten Oberfläche sind nicht ohne weiteres vergleichbar, so daß Behandlungsschritte, die von der einen Verfahrensweise her bekannt sind, nicht ohne weiteres auf eine der anderen Verfahrensweisen übertragen werden können.

HOECHST AKTIENGESELLSCHAFT
KALLE Niederlassung der Hoechst AG

-5-

Aus dem Stand der Technik sind die folgenden Modifizierungsarten der aufgerauhten Aluminiumoberflächen von
Druckplatten-Trägermaterialien bekannt:

Aus Wernick-Pinner, "The Surface Treatment and Finishing
of Aluminium and its Alloys", 4. Auflage, Vol. I, Robert-
Draper-Verlag, 1972, Seiten 209/210 ist das "Bleichen"
von elektrochemisch in verdünnter, wäßriger HCl-Lösung
aufgerauhten Aluminium-Blechen mit NaOH-Lösung bekannt,
um das Reflexionsverhalten von Druckplatten-Trägermaterialien zu erhöhen; bei dem derart vorbehandelten Aluminium ist die beim elektrochemischen Aufrauhen in der
HCl-Lösung entstandene dunkelgraue Oberfläche modifiziert.

Aus "Anodisch oxidierte Aluminiumdruckplatten für den
Offsetdruck" von E. Stahl in Papier und Druck, Fachbuchverlag - Leipzig, Nr. 10, 1963, Seiten 149 ff ist es
bekannt, daß Aluminium nach der elektrochemischen Aufrauhung in verdünnter, wäßriger $HNO_3$-Lösung und vor der
anodischen Oxidation in $H_2SO_4$-Lösung zur Neutralisation
von Säureresten mit Nitron (4,5-Dihydro-1,4-diphenyl-3,5-
phenylimino-1,2,4-triazol) behandelt wird, wobei sich mit
den $NO_3^-$-Ionen ein Niederschlag bildet.

In der DE-OS 16 21 115 (= US-PS 3 632 486) wird ein
mehrstufiges Verfahren zum elektrochemischen Aufrauhen
und Oxidieren von Folien oder Bändern aus Aluminium
beschrieben, bei dem zwischen der in verdünnter wäßriger
HCl-Lösung durchgeführten Aufrauh- und der in verdünnter

H O E C H S T   A K T I E N G E S E L L S C H A F T
KALLE  Niederlassung der Hoechst AG

-6-

wäßriger $H_2SO_4$-Lösung durchzuführenden Oxidations-Stufe zur "Entschmandung" ein verdünnte wäßrige NaOH-Lösung enthaltendes Bad vorgesehen ist. Die "Entschmandungs"-Stufe wird mit einer wäßrigen NaOH-Lösung einer Konzentration von 0,5 Gew.-% bei einer Temperatur von 40° C durchgeführt.

In der DE-AS 19 14 054 (= GB-PS 1 208 224) wird ein Verfahren zur Herstellung eines Aluminiumträgers für lithographische Druckplatten beschrieben, bei dem zwischen dem Aufrauhen mit Wechselstrom in einem verdünnte wäßrige HCl-Lösung enthaltenden Elektrolyten und der anodischen Oxidation in $H_2SO_4$-Lösung eine Spülstufe eingeschaltet ist, in der zurückbleibende Säure in einer verdünnten alkalischen Lösung (z. B. einer 1 %igen wäßrigen $NH_3$-Lösung) neutralisiert wird.

Bei dem Verfahren zur Herstellung von aluminiumhaltigen Druckplatten-Trägermaterialien durch mechanisches Aufrauhen und anschließende anodische Oxidation nach der DE-AS 22 51 382 (= US-PS 3 834 998) wird eine dazwischenliegende Ätzstufe eingeschaltet, bei der mit einer basischen oder sauren Lösung Metall in einer Menge von 0,5 bis 30 $g/m^2$ abgeätzt wird. Durch diese Zwischenbehandlung soll die Oberfläche nach dem mechanischen Aufrauhen von dunklen Rückständen befreit werden und die Entfernung der lichtempfindlichen Schicht von den bildfreien Bereichen beim Herstellen der Druckform erleichtert werden.

HOECHST AKTIENGESELLSCHAFT
KALLE Niederlassung der Hoechst AG

-7-

Das Verfahren zur Herstellung von Druckplattenträgern aus Aluminium gemäß der DE-OS 25 17 812 wird so durchgeführt, daß nach einer anodischen Oxidation des Aluminiums die derart erzeugte Oxidschicht mit einer basischen oder sauren Lösung in einem Bereich von 5 bis 70 Gew.-% wieder abgelöst wird; die anodische Oxidation verläuft in Schwefel-, Chrom-, Oxal- oder Phosphorsäure als Elektrolyten. Die so behandelten Aluminiumplatten sollen ein hohes Wasseraufnahmevermögen und eine verbesserte Haftfähigkeit gegenüber lichtempfindlichen Schichten aufweisen.

Aus der DE-OS 25 57 222 (entspricht inhaltlich der US-PS 3 935 080) ist eine kathodische Reinigungsstufe innerhalb eines Verfahrens zur Herstellung eines Aluminiumträgerbogens für Druckplatten bekannt, die zwischen der Aufrauhstufe in einem chloridhaltigen Elektrolyten und der anodischen Oxidationsstufe in einer $H_2SO_4$-Lösung eingeschoben wird.

Bei dem in der US-PS 2 344 510 beschriebenen Verfahren zum Aufrauhen von Druckplatten-Trägermaterialien aus Aluminium wird mechanisch aufgerauhtes Aluminium mit einer 5 %igen wäßrigen NaOH-Lösung nachbehandelt. Ein elektrochemisch in einer wäßrigen NaCl- oder HCl-Lösung aufgerauhtes Aluminium wird mit verdünnten Säuren wie $HNO_3$ oder $H_3BO_3$ nachgewaschen.

Das Verfahren zum Aufrauhen von Druckplatten-Trägermaterialien aus Aluminium nach der US-PS 3 073 765 wird so

0035730

durchgeführt, daß chemisch vorbehandeltes Aluminium unter Anwendung von Wechselstrom in verdünnter wäßriger HCl-Lösung, die auch noch NaCl oder $MgCl_2$ enthalten kann, aufgerauht wird; danach wird das aufgerauhte Material zur Passivierung der Oberfläche mit verdünnten wäßrigen Lösungen von $NH_3$, $Na_2SiO_3$ oder $(NH_4)_2 Cr_2O_7$ oder anderen Dichromaten behandelt.

Aus der US-PS 3 988 254 ist ein "Entschmandungs"-Reagens für aufgerauhtes Aluminium als wäßrige Lösung bekannt, die mindestens 0,1 Gew.-% eines wasserlöslichen Hydrogenperoxomonosulfats ($HSO_5^-$) und mindestens 0,1 Gew.-% eines wasserlöslichen Hydrogensulfats ($HSO_4^-$) enthält, wobei das Reagens sauer ist. Das behandelte Material kann, insbesondere mit einer zusätzlich aufgebrachten anodisch erzeugten Oxidschicht, als Trägermaterial für Druckplatten Verwendung finden; eine elektrochemische Aufrauhstufe ist nicht vorgesehen, der auftretende Schmand ist das Ergebnis einer rein-chemischen Aufrauhung.

Die aus dem Stand der Technik bekannten Verfahren weisen aber folgende Nachteile auf:

- Die mechanisch und/oder chemisch aufgerauhten Oberflächen von Druckplatten Trägermaterialien erfüllen nicht alle Praxis-Anforderungen an ein solches Material, sie können auch nicht in einer ökonomisch wichtigen, hohen Geschwindigkeit in den heute üblichen kontinuiuerlichen Anlagen der Hersteller erzeugt werden,

- die von den elektrochemisch-aufgerauhten Oberflächen eines Druckplatten-Trägermaterials her bekannten Modifizierungen führen zwar zu einer Entfernung von Verfärbungen ("Entschmandung"), insbesondere bei in verdünnter wäßriger HCl-Lösung elektrochemisch aufgerauhtem Aluminium, oder zur Beseitigung von Säureresten vor der oftmals anschließend durchzuführenden anodischen Oxidation des aufgerauhten Aluminiums, sie haben jedoch keinen Einfluß auf den Wischwasserverbrauch beim Drucken von mit diesen Materialien erzeugten Druckformen,

- das Abtragen von anodisch erzeugten Aluminiumoxidschichten ist ökonomisch wenig sinnvoll, da entweder die Oxidschicht zu dünn wird und damit die Druckauflage erniedrigt werden kann, oder eine dickere Oxidschicht als üblich vor dem Abtrag erzeugt werden muß, was zu einem unnötigen Energieaufwand führt.

Aufgabe der vorliegenden Erfindung ist es deshalb, ein Verfahren zur Herstellung von Druckplatten-Trägermaterialien vorzuschlagen, das zu einer Oberfläche führt, die es ermöglicht, eine Druckform mit verbesserter "Wasserführung" herzustellen, ohne daß diese Verbesserung gleichzeitig zu einer Erniedrigung der Druckauflage führt.

Die Erfindung geht aus von dem Verfahren zur Modifizierung mindestens einer Oberfläche von Druckplatten-Trägermaterialien auf der Basis von Aluminium oder seinen Legierungen mit wäßrig-alkalischen Lösungen nach der elektrochemischen Aufrauhung des Materials in verdünnten wäßrigen Säuren oder in wäßrigen Salzlösungen. Das erfindungsgemäße Verfahren ist dadurch gekennzeichnet, daß als Modifizierung ein Flächenabtrag von der aufgerauhten Oberfläche des Materials in einem Umfang von 0,4 bis 3,0 $g/m^2$ mit einer wäßrig-alkalischen Lösung eines pH-Werts von $\geq$ 11 während einer Dauer von 1 bis 90 sec und bei einer Temperatur von 30° C bis zum Siedepunkt der Lösung durchgeführt wird.

In bevorzugten Ausführungsformen des erfindungsgemäßen Verfahrens wird als Modifizierung ein Flächenabtrag in einem Umfang von 0,5 bis 2,5 $g/m^2$ mit einer wäßrig-alkalischen Lösung eines pH-Werts von $\geq$ 12, insbesondere 13, während einer Dauer von 2 bis 60 sec und bei einer Temperatur von 35° bis 80° C durchgeführt. In den weiteren Ausführungen ist unter dem Begriff Druckplatte in der Regel eine Druckplatte für den Flachdruck zu verstehen, die in der Hauptsache aus einem flächigen Träger aus einem oder mehreren Materialien und einer oder mehreren darauf angebrachten ebenfalls flächigen lichtempfindlichen Schichten besteht. Das erfindungsgemäße Verfahren kann diskontinuierlich oder insbesondere kontinuierlich durchgeführt werden.

Als Metallbasis für das band-, folien- oder plattenförmige Material wird Aluminium oder eine seiner Legierungen verwendet. Darunter sind bevorzugt (auch in den nachfolgenden Beispielen verwendet):

- "Reinaluminium" (DIN-Werkstoff Nr. 3.0255), d. h. bestehend aus $\geq$ 99,5 % Al und den folgenden zulässigen Beimengungen von (maximale Summe von 0,5 %) 0,3 % Si, 0,4 % Fe, 0,03 % Ti, 0,02 % Cu, 0,07 % Zn und 0,03 % sonstigem, oder

- "Al-Legierung 3003" (vergleichbar mit DIN-Werkstoff Nr. 3.0515), d. h. bestehend aus $\geq$ 98,5 % Al, den Legierungsbestandteilen 0 bis 0,3 % Mg und 0,8 bis 1,5 % Mn und den folgenden zulässigen Beimengungen von 0,5 % Si, 0,5 % Fe, 0,2 % Ti, 0,2 % Zn, 0,1 % Cu und 0,15 % sonstigem

zu verstehen.

Als wäßrig-alkalische Lösungen für die Modifizierung können wäßrige Lösungen von Alkalihydroxid, insbesondere NaOH, Alkaliphosphat, Alkalimetasilikat, Alkalicarbonat oder Mischungen dieser Verbindungen eingesetzt werden, soweit sie einen pH-Wert von $\geq$ 11 aufweisen. Auch handelsübliche "Aluminiumbeizen", die in wäßriger Lösung vorliegen und eine oder mehrere der vorher-aufgeführten Verbindungen und Zusätze wie Peroxide, Borate, Aluminate, Nitrate, Nitrite, Gluconate, Citrate oder organische Komplexbildner enthalten, können erfindungsgemäß eingesetzt werden. Die Konzentration dieser gelösten Komponenten der wäßrig-alkalischen Lösung liegt im allgemeinen im Bereich von 5 bis 80 g pro 1 l Lösung.

HOECHST AKTIENGESELLSCHAFT
KALLE Niederlassung der Hoechst AG

-12-

Neben den bei der einleitenden Aufführung des Standes der Technik bereits genannten Verfahren zur elektrochemischen Aufrauhung können im erfindungsgemäßen Verfahren vor der Modifizierungsstufe beispielsweise noch die folgenden Verfahren zum Einsatz kommen:

- die Aufrauhung von Aluminium in verdünnter, wäßriger HCl-Lösung unter Zusatz von weiteren Säuren wie Chromsäure oder Phosphorsäure nach der DE-AS 23 27 764 oder von Korrosionsinhibitoren wie Aminen, Aldehyden, Amiden, Harnstoff oder nichtionischen Tensiden nach der DE-AS 22 18 471,

- die Aufrauhung von Aluminium in verdünnter, wäßriger $HNO_3$-Lösung nach der AT-PS 224 656,

- die Aufrauhung von Aluminium in verdünnter, wäßriger HCl- oder $HNO_3$-Lösung mit speziellen Stromformen, wie einem Wechselstrom mit größerer Anoden- als Kathodenamplitude der Stromstärke nach der DE-AS 26 50 762,

- die Aufrauhung von Aluminium in verdünnter, wäßriger HCl- oder $HNO_3$-Lösung unter Zusatz von Borsäure oder Boraten nach der DE-AS 21 49 899,

- die Aufrauhung von Aluminium in einer neutralen, wäßrigen Salzlösung mit einer verhältnismäßig hohen Salzkonzentration nach der DE-OS 25 37 724, oder

- die Aufrauhung von Aluminium in einer sauren,
  wäßrigen Aluminiumsalzlösung mit einer verhältnismäßig hohen Salzkonzentration nach der DE-OS
  25 37 725.

Im allgemeinen liegen die Verfahrensparameter in der Aufrauhstufe in folgenden Bereichen: die Temperatur des
Elektrolyten zwischen 20 und 60° C, die Wirkstoff-(Säure-,
Salz-)Konzentration zwischen 5 und 100 g/l, die Stromdichte zwischen 15 und 130 A/dm$^2$, die Verweilzeit
zwischen 10 und 100 sec und die Elektrolytströmungsgeschwindigkeit an der Oberfläche des zu behandelnden Werkstücks zwischen 5 und 100 cm/sec; als Stromart wird
meistens Wechselstrom eingesetzt, es sind jedoch auch
modifizierte Stromarten wie Wechselstrom mit unterschiedlichen Amplituden der Stromstärke für den Anoden- und
Kathodenstrom möglich.

Die mittlere Rauhtiefe $R_z$ der aufgerauhten Oberfläche
liegt dabei im Bereich von etwa 1 bis 15 $\mu$m, insbesondere im Bereich von 4 bis 8 $\mu$m.

Die Rauhtiefe wird nach DIN 4768 in der Fassung vom
Oktober 1970 ermittelt, die Rauhtiefe $R_z$ ist dann das
arithmetische Mittel aus den Einzelrauhtiefen fünf aneinandergrenzender Einzelmeßstrecken. Die Einzelrauhtiefe
ist definiert als der Abstand zweier Parallelen zur
mittleren Linie, die innerhalb der Einzelmeßstrecken das
Rauhheitsprofil am höchsten bzw. am tiefsten Punkt
berühren. Die Einzelmeßstrecke ist der fünfte Teil der

HOECHST  AKTIENGESELLSCHAFT
KALLE  Niederlassung der Hoechst AG

-14-

senkrecht auf die mittlere Linie projizierten Länge des unmittelbar zur Auswertung benutzten Teils des Rauhheitsprofils. Die mittlere Linie ist die Linie parallel zur allgemeinen Richtung des Rauhheitsprofils von der Form des geometrisch-idealen Profils, die das Rauhheitsprofil so teilt, daß die Summe der werkstofferfüllten Flächen über ihr und der werkstofffreien Flächen unter ihr gleich sind.

Nach der erfindungsgemäß abtragenden Modifizierungsstufe, die sich an eines der elektrochemischen Aufrauhverfahren des Standes der Technik anschließt, wird in einer weiteren, bevorzugt anzuwendenden Verfahrensstufe, das Material anodisch oxidiert, um beispielsweise den Abrieb und die Haftungseigenschaften der Oberfläche des Trägermaterials zu verbessern. Zur anodischen Oxidation können die üblichen Elektrolyte wie $H_2SO_4$, $H_3PO_4$, $H_2C_2O_4$, Amidosulfonsäure, Sulfobernsteinsäure, Sulfosalicylsäure oder deren Mischungen eingesetzt werden. Es wird beispielsweise auf folgende Standardmethoden für den Einsatz von $H_2SO_4$ enthaltenden wäßrigen Elektrolyten für die anodische Oxidation von Aluminium hingewiesen (siehe dazu z. B. M. Schenk, Werkstoff Aluminium und seine anodische Oxydation, Francke Verlag - Bern, 1948, Seite 760; Praktische Galvanotechnik, Eugen G. Leuze Verlag - Saulgau, 1970, Seite 395 ff und Seiten 518/519; W. Hübner und C. T. Speiser, Die Praxis der anodischen Oxidation des Aluminiums, Aluminium Verlag - Düsseldorf, 1977, 3. Auflage, Seiten 137 ff):

- Das Gleichstrom-Schwefelsäure-Verfahren, bei dem in einem wäßrigen Elektrolyten aus üblicherweise ca. 230 g $H_2SO_4$ pro 1 1 Lösung bei 10° bis 22° C und einer Stromdichte von 0,5 bis 2,5 A/dm$^2$ während 10 bis 60 min anodisch oxidiert wird. Die Schwefelsäurekonzentration in der wäßrigen Elektrolytlösung kann dabei auch bis auf 8 bis 10 Gew.-% $H_2SO_4$ (ca. 100 g $H_2SO_4$/l) verringert oder auch auf 30 Gew.-% (365 g $H_2SO_4$/l) und mehr erhöht werden.

- Die "Hartanodisierung" wird mit einem wäßrigen, $H_2SO_4$ enthaltenden Elektrolyten einer Konzentration von 166 g $H_2SO_4$/l (oder ca. 230 g $H_2SO_4$/l) bei einer Betriebstemperatur von 0° bis 5° C, bei einer Stromdichte von 2 bis 3 A/dm$^2$, einer steigenden Spannung von etwa 25 bis 30 V zu Beginn und etwa 40 bis 100 V gegen Ende der Behandlung und während 30 bis 200 min durchgeführt.

Neben den im vorhergehenden Absatz und den bei der einleitenden Aufführung des Standes der Technik bereits genannten Verfahren zur anodischen Oxidation von Druckplatten-Trägermaterialien können beispielsweise noch die folgenden Verfahren zum Einsatz kommen: die anodische Oxidation von Aluminium in einem wäßrigen $H_2SO_4$ enthaltenden Elektrolyten, dessen $Al^{3+}$-Ionengehalt auf Werte von mehr als 12 g/l eingestellt wird (nach der DE-OS 28 11 396), in einem wäßrigen, $H_2SO_4$ und $H_3PO_4$ enthaltenden Elektrolyten (nach der DE-OS 27 07 810 bzw. US-PS 4 049 504) oder in einem wäßrigen, $H_2SO_4$, $H_3PO_4$ und $Al^{3+}$-

HOECHST AKTIENGESELLSCHAFT
KALLE Niederlassung der Hoechst AG

-16-

Ionen enthaltenden Elektrolyten (nach der DE-OS
28 36 803). Zur anodischen Oxidation wird bevorzugt
Gleichstrom verwendet, es kann jedoch auch Wechselstrom
oder eine Kombination dieser Stromarten (z. B. Gleichstrom mit überlagertem Wechselstrom) eingesetzt werden.
Die Schichtgewichte an Aluminiumoxid bewegen sich im
Bereich von 1 bis 10 g/m$^2$, entsprechend einer Schichtdicke von etwa 0,3 bis 3,0 /um.

Der Variante des erfindungsgemäßen Verfahrens mit der
Stufe einer anodischen Oxidation des Druckplatten-Trägermaterials aus Aluminium können auch eine oder mehrere
Nachbehandlungsstufen nachgestellt werden. Dabei wird
unter Nachbehandeln insbesondere eine hydrophilierende
chemische oder elektrochemische Behandlung der Aluminiumoxidschicht verstanden, beispielsweise eine Tauchbehandlung des Materials in einer wäßrigen Polyvinylphosphonsäure-Lösung nach der DE-PS 16 21 478 (= GB-PS
1 230 447), eine Tauchbehandlung in einer wäßrigen
Alkalisilikat-Lösung nach der DE-AS 14 71 707 (= US-PS
3 181 461) oder eine elektrochemische Behandlung (Anodisierung) in einer wäßrigen Alkalisilikat-Lösung nach der
DE-OS 25 32 769 (= US-PS 3 902 976). Diese Nachbehandlungsstufen dienen insbesondere dazu, die bereits für
viele Anwendungsgebiete ausreichende Hydrophilie der Aluminiumoxidschicht noch zusätzlich zu steigern, wobei die
übrigen bekannten Eigenschaften dieser Schicht mindestens
erhalten bleiben.

HOECHST AKTIENGESELLSCHAFT
KALLE Niederlassung der Hoechst AG

-17-

Eine weitere Lösung der gestellten Aufgabe ist die Verwendung des erfindungsgemäß elektrochemisch aufgerauhten, modifizierten und gegebenenfalls anodisch oxidierten und noch hydrophilierend nachbehandelten Materials in einem Verfahren zur Herstellung von eine lichtempfindliche Schicht tragenden Druckplatten. Dabei wird entweder beim Hersteller von vorsensibilisierten Druckplatten oder beim Beschichten eines Trägermaterials beim Verbraucher das Trägermaterial mit einer der folgenden lichtempfindlichen Massen beschichtet:

Als lichtempfindliche Schichten sind grundsätzlich alle Schichten geeignet, die nach dem Belichten, gegebenenfalls mit einer nachfolgenden Entwicklung und/oder Fixierung eine bildmäßige Fläche liefern, von der gedruckt werden kann.

Neben den auf vielen Gebieten verwendeten Silberhalogenide enthaltenden Schichten sind auch verschiedene andere bekannt, wie sie z. B. in "Light-Sensitive Systems" von Jaromir Kosar, John Wiley & Sons Verlag, New York 1965 beschrieben werden: die Chromate und Dichromate enthaltenden Kolloidschichten (Kosar, Kapitel 2); die ungesättigte Verbindungen enthaltenden Schichten, in denen diese Verbindungen beim Belichten isomerisiert, umgelagert, cyclisiert oder vernetzt werden (Kosar, Kapitel 4); die photopolymerisierbare Verbindungen enthaltenden Schichten, in denen Monomere oder Präpolymere gegebenenfalls mittels eines Initiators beim Belichten polymerisieren (Kosar, Kapitel 5); und die o-Diazo-

HOE.CHST AKTIENGESELLSCHAFT
KALLE Niederlassung der Hoechst AG

-18-

chinone wie Naphthochinondiazide, p-Diazo-chinone oder
Diazoniumsalz-Kondensate enthaltenden Schichten (Kosar,
Kapitel 7). Zu den geeigneten Schichten zählen auch die
elektrophotographischen Schichten, d. h. solche die einen
anorganischen oder organischen Photoleiter enthalten.
Außer den lichtempfindlichen Substanzen können diese
Schichten selbstverständlich noch andere Bestandteile wie
z. B. Harze, Farbstoffe oder Weichmacher enthalten.

Insbesondere können die folgenden lichtempfindlichen
Massen oder Verbindungen bei der Beschichtung der nach
dem erfindungsgemäßen Verfahren hergestellten Trägermaterialien eingesetzt werden:

Positiv arbeitende o-Chinondiazid-, bevorzugt o-Naphthochinondiazid-Verbindungen, die beispielsweise in den DE-
PSen 854 890, 865 109, 879 203, 894 959, 938 233,
1 109 521, 1 144 705, 1 118 606, 1 120 273 und 1 124 817
beschrieben werden.

Negativ arbeitende Kondensationsprodukte aus aromatischen
Diazoniumsalzen und Verbindungen mit aktiven Carbonylgruppen, bevorzugt Kondensationsprodukte aus Diphenylamindiazoniumsalzen und Formaldehyd, die beispielsweise
in den DE-PSen 596 731, 1 138 399, 1 138 400, 1 138 401,
1 142 871, 1 154 123, den US-PSen 2 679 498 und 3 050 502
und der GB-PS 712 606 beschrieben werden.

Negativ arbeitende Mischkondensationsprodukte aromatischer Diazoniumverbindungen, beispielsweise nach der DE-OS 20 24 244, die mindestens je eine Einheit der allgemeinen Typen A(-D)$_n$ und B verbunden durch ein zweibindiges, von einer kondensationsfähigen Carbonylverbindung abgeleitetes Zwischenglied aufweisen. Dabei sind diese Symbole wie folgt definiert: A ist der Rest einer mindestens zwei aromatische carbo- und/oder heterocyclische Kerne enthaltenden Verbindung, die in saurem Medium an mindestens einer Position zur Kondensation mit einer aktiven Carbonylverbindung befähigt ist. D ist eine an ein aromatisches Kohlenstoffatom von A gebundene Diazoniumsalzgruppe; n ist eine ganze Zahl von 1 bis 10; und B der Rest einer von Diazoniumgruppen freien Verbindung, die in saurem Medium an mindestens einer Position des Moleküls zur Kondensation mit einer aktiven Carbonylverbindung befähigt ist.

Positiv arbeitende Schichten nach der DE-OS 26 10 842, die eine bei Bestrahlung Säure abspaltende Verbindung, eine Verbindung, die mindestens eine durch Säure abspaltbare C-O-C-Gruppe aufweist (z. B. eine Orthocarbonsäureestergruppe oder eine Carbonsäureamidacetalgruppe) und gegebenenfalls ein Bindemittel enthalten.

Negativ arbeitende Schichten aus photopolymerisierbaren Monomeren, Photoinitiatoren, Bindemitteln und gegebenenfalls weiteren Zusätzen. Als Monomere werden dabei beispielsweise Acryl- und Methacrylsäureester oder Umsetzungsprodukte von Diisocyanaten mit Partialestern mehrwertiger Alkohole eingesetzt, wie es beispielsweise in den US-PSen 2 760 863 und 3 060 023 und den DE-OSen

H O E C H S T   A K T I E N G E S E L L S C H A F T
KALLE  Niederlassung der Hoechst AG

-20-

20 64 079 und 23 61 041 beschrieben wird. Als Photoinitiatoren eignen sich u. a. Benzoin, Benzoinether, Mehrkernchinone, Acridinderivate, Phenazinderivate, Chinoxalinderivate, Chinazolinderivate oder synergistische Mischungen verschiedener Ketone. Als Bindemittel können eine Vielzahl löslicher organischer Polymere Einsatz finden, z. B. Polyamide, Polyester, Alkydharze, Polyvinylalkohol, Polyvinylpyrrolidon, Polyethylenoxid, Gelatine oder Celluloseether.

Es können auch photohalbleitende Schichten, wie sie z. B. in den DE-PSen 1 117 391, 15 22 497, 15 72 312, 23 22 046 und 23 22 047 beschrieben werden, auf die erfindungsgemäß hergestellten Trägermaterialien aufgebracht werden, wodurch hochlichtempfindliche, elektrophotographische Druckplatten entstehen.

Die nach dem erfindungsgemäßen Verfahren hergestellten Druckplatten-Trägermaterialien zeigen insbesondere folgende Eigenschaften, die sie bei ihrer Anwendung für das Drucken gegenüber nach dem Stand der Technik elektrochemisch aufgerauhten und modifizierten Materialien auszeichnen: Einen geringeren Feuchtwasserverbrauch und eine geringere Neigung zum Tonen während des Druckvorgangs, und nach einer an die Modifizierung anschließenden anodischen Oxidation eine geringere Adsorptivität als bei herkömmlichen Druckplatten, was beispielsweise die Möglichkeit des Aufbaus dickerer und damit abriebfesterer Oxidschichten eröffnet.

HOECHST AKTIENGESELLSCHAFT
KALLE Niederlassung der Hoechst AG

-21-

Prozentangaben in den folgenden Beispielen sind auf das Gewicht bezogen, Gew.-Teile stehen zu Vol.-Teilen im gleichen Verhältnis wie kg zu l. Bei der Beurteilung der nach dem erfindungsgemäßen Verfahren hergestellten Aluminiummaterialien werden die folgenden Standardmethoden herangezogen:

- <u>Prüfung der Güte der Verdichtung anodisch erzeugter Oxidschichten im Anfärbeversuch</u> (angelehnt an DIN 50 946 in der Ausgabe vom Juni 1968): Diese qualitative Meßmethode läßt insbesondere in Kombination mit einer nachfolgenden Farbortbestimmung Aussagen darüber zu, ob und in welchem Ausmaß die anodisch oxidierte Oberfläche eines Aluminiumaterials zur "Schleierbildung" neigt. Zur Messung wird ein flächiger Materialabschnitt von 5 cm · 12 cm hälftig während 20 min in eine Lösung von 0,5 g/l an Aluminium-Blau $^{\circledR}$ Solvay Blue BN 150 der ICI) in H$_2$O dest. bei 40° bis 45° C eingetaucht, mit H$_2$O dest. abgespült und getrocknet. Der Grad der Anfärbung ist ein Maß für die Güte der Verdichtung. Je weniger Farbstoff aufgenommen worden ist, desto besser ist die Verdichtung, d. h. je weniger neigt die untersuchte Oberfläche zur "Schleierbildung".

- <u>Farbortbestimmung</u> (nach DIN 5033 Blatt 1 vom Juli 1962, Blatt 3 vom April 1954, Blatt 6 vom September 1964 und Blatt 7 vom Oktober 1966): Dabei werden die Farbmaßzahlen für den ungefärbten und den angefärbten Teil der Probe (angefärbt mit

HOECHST AKTIENGESELLSCHAFT
KALLE Niederlassung der Hoechst AG

-22-

Aluminium-Blau) bestimmt. Als Normlichtart wird die Normlichtart C (spektrale Strahlungsverteilung einer gasgefüllten Wolfram-Glühlampe der Verteilungstemperatur von 2854 K) verwendet und die drei Farbwerte der zu messenden Farbvalenz bestimmt. Als Ergebnis können die trichromatischen Farbmaßzahlen des Normvalenz-Systems angegeben werden, in der Praxis genügt (zumindest im vorliegenden Falle) häufig bereits die Angabe eines Normfarbwertes oder Normfarbwertanteils. Bei der Farbortbestimmung der Probe ist dann die Differenz zwischen den Normfarbwertanteilen $x_I$ des ungefärbten Teils der Probe und $x_{II}$ des angefärbten Teils der Probe ein Maß für die Verdichtung der Oberfläche, d. h. je größer der Differenzwert desto weniger dicht ist die Oberfläche und desto eher tritt die "Schleierbildung" auf.

– Bestimmung des Feuchtwasserverbrauchs
Die Antragsmenge des Feuchtwassers wird durch eine Anzeigevorrichtung in einem Feuchtwerk der Firma Dahlgren bestimmt. Sie ist kein absolutes Maß für den Feuchtwasserverbrauch, es können aber die Angaben dieser Vorrichtung in Skalenteilen von verschiedenen Druckdurchgängen miteinander verglichen werden (relative Maße).

Beispiel 1
Ein 0,3 mm dickes walzblankes Aluminiummuster wird mit einer wäßrigen Lösung eines Gehalts von 20 g NaOH und 20 g $Al^{3+}$-Ionen (als Natrium-Aluminat eingesetzt) pro 1 Lösung bei 83° C während 8 sec entfettet und vorgebeizt. Nach einer sauren Zwischenwaschung (Dekapierung) wird die Oberfläche des Aluminiummusters in einer wäßrigen Lösung von $Al(NO_3)_3 \cdot 9\ H_2O$ und $HNO_3$ (Lösung in entsalztem Wasser) bei einer Temperatur von 40 bis 45° C unter Wechselstromeinwirkung einer Stromdichte von 45 $A/dm^2$ unter starker Badumwälzung bis zu einer Rauhtiefe $R_z$ von 7 /um aufgerauht. Unter Zwischenschalten einer Wäsche mit Wasser wird das Aluminiummuster in einem Beizbad, welches sich in seiner Zusammensetzung nicht vom oben aufgeführten Vorbeizbad unterscheidet, für 8 sec bei 60° C zwischenbehandelt; der pH-Wert des Bades beträgt 13,5, es wird ein Abtrag von etwa 1,5 $g/m^2$ erzielt.

Nach einer weiteren Zwischenwaschung wird die Aluminiumoberfläche in einem wäßrigen Anodisierbad eines Gehalts von 150 g/l $H_2SO_4$ und 5 g/l $Al^{3+}$-Ionen (als $Al_2(SO_4)_3$ eingesetzt) bei 40° C durch Gleichstromeinwirkung einer Stromdichte von 14 $A/dm^2$ während 25 sec anodisch oxidiert. Das Muster wird mit Wasser gewaschen und getrocknet.

Zur Herstellung einer vorsensibilisierten Druckplatte aus diesem erfindungsgemäß modifizierten Material wird eine Lösung mit folgenden Bestandteilen verwendet:

0,58 Gew.-Teile des Veresterungsproduktes aus 1 Mol
2,2'-Dihydroxy-dinaphthyl-(1,1')-methan
und 2 Mol Naphthochinon-(1,2)-diazid-
(2)-5-sulfonsäurechlorid

HOECHST AKTIENGESELLSCHAFT
KALLE Niederlassung der Hoechst AG

-24-

1,16 Gew.-Teile des p-Cumylphenolesters der Naphtho-
chinon-(1,2)-diazid-(2)-4-sulfonsäure

6,92 Gew.-Teile Novolakharz (Erweichungspunkt 112° bis
118° C, Gehalt an phenolischen OH-
Gruppen 14 Gew.-%)

0,08 Gew.-Teile Kristallviolettbase

0,26 Gew.-Teile Naphthochinon-(1,2)-diazid-(2-)-4-sulfo-
säurechlorid

36,00 Gew.-Teile Ethylenglykol-mono-ethylether

47,00 Gew.-Teile Tetrahydrofuran

8,00 Gew.-Teile Butylacetat

Das auf dem anodisierten Träger aufgebrachte Gewicht der
lichtempfindlichen Schicht beträgt etwa 3 g/m$^2$. Die
Platte wird unter einer Positivvorlage in an sich
bekannter Weise mit einer 5 kW Metallhalogenid-Lampe
belichtet und mit einer wäßrig alkalischen Lösung
entwickelt.

Von der so hergestellten Druckform lassen sich mehr als
200 000 Drucke von guter Qualität herstellen. Das Druckverhalten ist sehr gut. Auch bei sparsamer Wasserzufuhr
neigt die Platte nicht zur Farbannahme in den Nichtbildstellen ("Tonen"). Die Druckform verbraucht ca. 10 bis

HOECHST AKTIENGESELLSCHAFT
KALLE Niederlassung der Hoechst AG

-25-

15 % weniger Feuchtwasser als eine Vergleichsdruckform, deren Trägermaterial zwischen dem Aufrauhen und der anodischen Oxidation nicht alkalisch-abtragend behandelt wurde, aber sonst gleichwertig aufgebaut ist.

Das erfindungsgemäß zwischenbehandelte Muster wird zur Messung der "Schleierbildungs"-Empfindlichkeit der späteren Druckform vor Aufbringen der lichtempfindlichen Schicht angefärbt, es liefert eine Farbwertdifferenz $x_I - x_{II}$ von $19,1 \cdot 10^{-3}$ während das unmodifizierte Vergleichsmuster einen Differenzwert von $38,8 \cdot 10^{-3}$ liefert.

Beispiel 2

Ein 0,3 mm dickes walzblankes Aluminiummuster wird nach den Angaben des Beispiels 1 vorgebeizt und in einer wäßrigen $HNO_3/Al^{3+}$-Ionen Lösung bei einer Stromdichte von 30 $A/dm^2$ bis zu einer Rauhtiefe $R_z$ von etwa 4,5 /um aufgerauht. Die Zwischenbeizung erfolgt während 8 sec bei 75° C, wobei ein Abtrag von etwa 2,7 $g/m^2$ erzielt wird. Nach einer Dekapierung wird die Aluminiumoberfläche anodisch oxidiert und anschließend bei 60° C mit einer 0,2 %igen wäßrigen Lösung von Polyvinylphosphonsäure (Molekulargewicht etwa 100 000) behandelt, mit Wasser gespült und getrocknet.

Die Beschichtung erfolgt mit einem lichtempfindlichen Gemisch aus 1,4 Gew.-Teilen Mischkondensat aus 1 Mol 3-Methoxy-diphenylamin-4-diazonium-sulfat und 1 Mol 4,4'-Bis-methoxymethyldiphenyl-ether, hergestellt in 85 %iger wäßriger Phosphorsäure und als Mesitylensulfonat ausgefällt, 0,2 Gew.-Teilen p-Toluol-sulfonsäure-monohydrat,
3 Gew.-Teilen Polyvinylbutyral (enthaltend 69 bis 71 %
Polyvinyl-butyral-, 1 % Polyvinylacetat- und 24 bis 27 %
Polyvinylalkoholeinheiten, die Viskosität einer 5 %igen
Lösung in Butanol bei 20° C beträgt 20 - 30 mPa · s), 80
Vol.-Teilen Ethylenglykolmonomethylether und 20 Vol.-
Teilen Butylacetat. Die unter einem Negativ belichtete
Diazo-Mischkondensatschicht wird mit einer Mischung aus
50 Gew.-Teilen Wasser, 15 Gew.-Teilen Isopropanol, 20
Gew.-Teilen n-Propanol, 12,5 Gew.-Teilen n-Propylacetat,
1,5 Gew.-Teilen Polyacrylsäure und 1,5 Gew.-Teilen Essigsäure entwickelt.

Von dieser Druckform lassen sich mehr als 150 000 Drucke
von guter Qualität herstellen.

Im Vergleich zu einer gleichartig hergestellten Druckform
ohne die erfindungsgemäße, alkalisch-abtragende Zwischenbehandlung verbraucht die in Beispiel 2 beschriebene
Druckform ca. 15 - 20 % Feuchtwasser weniger.

Beispiel 3
Ein 0,3 mm dickes walzblankes Aluminiumband wird in üblicher Weise mit einer wäßrigen Lösung von 20 g NaOH/l
bei einer Temperatur von 80° C während 10 sec entfettet
und gereinigt. Nach Spülung mit Wasser wird sauer dekapiert und nach den Angaben des Beispiels 1 elektrochemisch verhältnismäßig "flach" bis zu einer Rauhtiefe
$R_z$ von ewa 3 µm aufgerauht. Anschließend erfolgt eine alkalische Zwischenbeizung mit einer wäßrigen Lösung von 20 g NaOH und 20 g $Al^{3+}$-Ionen (zugesetzt als Natriumaluminat) pro l; Temperatur 35° C, Einwirkzeit 8 sec, Abtrag ca. 0,8 $g/m^2$, pH-Wert ca. 13,5. Das gewaschene, sauer dekapierte und nachgewaschene Band erhält eine anodisch in Schwefelsäure erzeugte Oxidschicht und wird wie in Beispiel 2 mit Polyvinylphosphonsäure nachbehandelt, die lichtempfindliche Beschichtung erfolgt wie im Beispiel 1 angegeben.

Nach Belichtung und Entwicklung wird die fertige Druckform auf einer Druckmaschine angedruckt und der geringste Wasserbedarf für einwandfreie Druckergebnisse durch langsames Zurückstellen der Feuchtwerkeinstellung ermittelt: Er ist bei einer Druckgeschwindigkeit von 6.000 Bogen in der Stunde bei 34 Skalenteilen erreicht und erhöht sich bei einer Druckgeschwindigkeit von 8.000 Bogen/h auf 38 Skalenteile. Eine Vergleichsdruckform (hergestellt ohne alkalisch-abtragende Zwischenbehandlung) hat dagegen einen minimalen Wasserbedarf von 36 bzw. 40 Skalenteilen, d. h. er liegt um ca. 5,5 - 6 % höher.

Beispiel 4

Ein 0,3 mm dickes walzblankes Aluminiumband wird nach den Angaben des Beispiels 3 entfettet und gereinigt. Nach Spülung mit Wasser und saurer Dekapierung erfolgt eine elektrochemische Aufrauhung in der $HNO_3/Al^{3+}$-Ionen enthaltenden Lösung nach den Angaben des Beispiel 2 bis zu einer Rauhtiefe $R_z$ von etwa 6 /um. Die abtragende Zwischenbehandlung erfolgt nach den Angaben des Beispiels 3 bei 45° C und 8 sec, der Abtrag beträgt etwa 1,1 g/m$^2$. Das gewaschene Band erhält eine anodisch in Schwefelsäure erzeugte Oxidschicht nach Beispiel 1 und wird mit der dort angegebenen lichtempfindlichen Beschichtung versehen, belichtet und entwickelt.

Beim Andruck nach den Angaben des Beispiels 3 wird bei einer Druckgeschwindigkeit von 6.000 Bogen/h ein minimaler Wasserbedarf von 34 Skalenteilen und bei 8.000 Bogen/h von 38 Skalenteilen Feuchtwerkseinstellung beobachtet. Die nicht alkalisch-abtragend zwischengebeizte Vergleichsdruckform hat dagegen einen Wasserbedarf von 35 bzw. 39 Skalenteilen, d. h. er liegt um ca. 2,5 - 3 % höher.

Beim Auflagendruck steigt der Wasserbedarf langsam an, der Abstand im Verbrauch zwischen erfindungsgemäß zwischenbehandelter und Vergleichsdruckform bleibt jedoch gleich. Die Auflagenleistung der erfindungsgemäß zwischenbehandelte Druckform wird durch die Zwischenbehandlung nicht verringert und liegt über 150 000 Drucken.

Vergleichsbeispiel

Ein nach den Angaben des Beispiels 3 elektrochemisch aufgerauhtes Aluminiumband wird mit Schwefelsäure (900 g $H_2SO_4$/l) bei 65° C und 60 sec Einwirkdauer sauer-abtragend zwischenbehandelt (Abtrag ca. 1,5 g/m$^2$) und in Schwefelsäure anodisch oxidiert. Nach lichtempfindlicher Beschichtung nach den Angaben des Beispiels 1 wird kopiert und entwickelt und im Druckversuch der Wasser-

0035730

bedarf festgestellt. Bei 6.000 Bogen/h bzw. 8.000 Bogen/h Druckgeschwindigkeit muß das Feuchtwerk auf 34 bzw. 38 Skalenteile eingestellt werden. Die nicht zwischenbehandelte Vergleichs-Druckform erfordert eine Feuchtwerkeinstellung von 36 bzw. 40 Skalenteilen. Die sauer-abtragend zwischengebeizte Druckform erreicht jedoch nur eine Druckauflage von 120 000 guten Drucken, während erfindungsgemäß alkalisch-abtragend zwischenbehandelte und Druckformen ohne jede Zwischenbehandlung mindestens 150 000 gute Drucke ermöglichen.

Wird bei saurer Zwischenbehandlung die Temperatur bei gleichbleibender Wirkzeit auf 75 - 80° C erhöht, so nimmt der Abtrag auf 2,5 - 3 $g/m^2$ zu. Die Oberfläche der Druckplatte wird dabei durch Ablösung feinerer Aufrauhelemente weitgehend eingeebnet. Als Folge haftet die Kopierschicht weniger gut, was sich durch eine sehr schlechte Druckauflage (10 - 15.000) bemerkbar macht.

HOECHST AKTIENGESELLSCHAFT
KALLE · Niederlassung der Hoechst AG

Hoe 80/K 006             -30-           27. Februar 1981
                                        WLK-Dr.I.-dg

### Patentansprüche

1. Verfahren zur Modifizierung mindestens einer Oberfläche von Druckplatten-Trägermaterialien auf der Basis von Aluminum oder seinen Legierungen mit wäßrig-alkalischen Lösungen nach der elektrochemischen Aufrauhung des Materials in verdünnten wäßrigen Säuren oder in wäßrigen Salzlösungen, dadurch gekennzeichnet, daß als Modifizierung ein Flächenabtrag von der aufgerauhten Oberfläche des Materials in einem Umfang von 0,4 bis 3,0 $g/m^2$ mit einer wäßrig-alkalischen Lösung eines pH-Werts von $\geqq$ 11 während einer Dauer von 1 bis 90 sec und bei einer Temperatur von 30° C bis zum Siedepunkt der Lösung durchgeführt wird.

2. Verfahren nach Anspruch 1, dadurch gekennzeichnet, daß der Flächenabtrag in einem Umfang von 0,5 bis 2,5 $g/m^2$ durchgeführt wird.

3. Verfahren nach Anspruch 1 oder 2, dadurch gekennzeichnet, daß die Modifizierung mit einer wäßrig-alkalischen Lösung eines pH-Werts von $\geqq$ 12 durchgeführt wird.

4. Verfahren nach einem der Ansprüche 1 bis 3, dadurch gekennzeichnet, daß die Modifizierung während einer Dauer von 2 bis 60 sec durchgeführt wird.

5. Verfahren nach einem der Ansprüche 1 bis 4, dadurch gekennzeichnet, daß die Modifizierung bei einer Temperatur von 35° bis 80° C durchgeführt wird.

-31-

6. Verfahren nach einem der Ansprüche 1 bis 5, dadurch gekennzeichnet, daß nach Durchführung der Modifizierung das aufgerauhte und modifizierte Material anodisch mit Gleichstrom in einem wäßrig-sauren Elektrolyten oxidiert wird.

7. Verfahren nach Anspruch 6, dadurch gekennzeichnet, daß nach der anodischen Oxidation das Material hydrophilierend nachbehandelt wird.

8. Verfahren zur Herstellung einer Druckplatte unter Verwendung des nach einem der Ansprüche 1 bis 7 hergestellten Trägermaterials, dadurch gekennzeichnet, daß auf die aufgerauhte, modifizierte und gegebenenfalls anodisch oxidierte Oberfläche eine lichtempfindliche Schicht aufgebracht wird.

9. Verfahren nach Anspruch 8, dadurch gekennzeichnet, daß die gegebenenfalls angefärbte lichtempfindliche Schicht Diazoverbindungen, Diazochinone, Diazomischkondensate oder photopolymerisierbare Verbindungen enthält.